# EUROPEAN PATENT APPLICATION

(11) **EP 3 398 906 A1**
(43) Date of publication of application: **07.11.2018**
(21) Application number: 16881805.2
(22) Date of filing: 28.12.2016
(51) Int. Cl.: C01B 32/152, B32B 5/02, B32B 9/00, B82Y 40/00, C01B 32/158, C09K 5/14, H01L 23/36, H05K 7/20

(54) **CARBON NANOTUBE JOINING SHEET AND METHOD FOR PRODUCING CARBON NANOTUBE JOINING SHEET**

(30) Priority: 28.12.2015 JP 2015256721
(71) Applicant: Hitachi Zosen Corporation, Osaka-shi, Osaka 559-8559 (JP)
(72) Inventor: INOUE, Tetsuya, Osaka-shi Osaka 559-8559 (JP); MARUYAMA, Hiroyuki, Osaka-shi Osaka 559-8559 (JP)
(74) Representative: Grünecker Patent- und Rechtsanwälte PartG mbB
(86) International application number: PCT/JP2016/089030
(87) International publication number: WO 2017/115831

(57) **Abstract**

A carbon nanotube bonded sheet includes a fixture sheet formed from a sintered body of an inorganic material, and a carbon nanotube array sheet bonded to the sintered inorganic material of the fixture sheet.

## Description

### TECHNICAL FIELD

The present invention relates to a carbon nanotube bonded sheet and a method for producing a carbon nanotube bonded sheet.

### BACKGROUND ART

There has been known that a thermal conductive material (Thermal Interface Material: hereinafter referred to as TIM) is disposed between an electronic component and a heat sink to reduce the gap between the electronic component and the heat sink to efficiently conduct heat generated from the electronic component to the heat sink. For such a TIM, a polymer sheet composed of a polymer material and a silicone grease has been known.

However, the polymer sheet cannot sufficiently conform to subtle bumps and dents (surface roughness) on the surfaces of the electronic component and heat sink, and the subtle bumps and dents may cause gaps between the electronic component and the heat sink, and there are limitations as to improvement in thermal conductivity.

The silicone grease can conform to the subtle bumps and dents on the surfaces of the electronic component and heat sink, but repetitive changes in temperature may cause pumping out (discharge from between the electronic component and heat sink), and it is difficult to secure the thermal conductivity of the TIM for a long period of time.

Thus, a TIM that is capable of conforming to the subtle bumps and dents on the surfaces of the electronic component and heat sink and capable of securing thermal conductivity for a long period of time has been desired, and use of carbon nanotube (hereinafter referred to as CNT) for TIM has been examined.

For example, Patent Document 1 has proposed a thermal interface pad including a substrate and CNT arranged in array on both sides of the substrate (for example, see Patent Document 1).

Such a thermal interface pad is produced by allowing CNT to grow on both surfaces of the substrate by chemical vapor deposition. In such a thermal interface pad, CNT is disposed on both sides of the substrate, and therefore the CNT can be allowed to conform to the subtle bumps and dents on the surface of the electronic component and heat sink.

### Citation List

### Patent Document

Patent document 1: WO2015-526904

### SUMMARY OF THE INVENTION

### PROBLEM TO BE SOLVED BY THE INVENTION

However, the thermal interface pad described in patent document 1 is produced by allowing the CNT to grow on both sides of the substrate by chemical vapor deposition, and therefore adhesive strength between the substrate and CNT cannot be secured sufficiently. Therefore, when the thermal interface pad is used as TIM, CNT may be dropped off from the substrate. In this case, it is difficult to secure thermal conductivity of the thermal interface pad, and the dropped CNT may cause short circuit of electronic components.

Thus, an object of the present invention is to provide a carbon nanotube bonded sheet which is capable of conforming to subtle dents and bumps on the surface of an object, and suppressing dropping out of the carbon nanotube; and a method for producing a carbon nanotube bonded sheet.

### MEANS FOR SOLVING THE PROBLEM

The present invention [1] includes a carbon nanotube bonded sheet including a fixture sheet formed from a sintered body of an inorganic material and a carbon nanotube array sheet bonded to the sintered body of the fixture sheet.

With this configuration, the carbon nanotube bonded sheet includes the carbon nanotube array sheet, and therefore when the carbon nanotube bonded sheet is allowed to contact an object, a plurality of CNTs in the carbon nanotube array sheet are allowed to conform to the subtle dents and bumps of the object surface.

Furthermore, the carbon nanotube array sheet is bonded to the sintered body of the fixture sheet, and therefore the CNT in the carbon nanotube array sheet can be suppressed from dropping from the fixture sheet.

The present invention [2] includes the carbon nanotube bonded sheet of [1] above, wherein the inorganic material contains silicon and/or titanium, and the sintered body includes a sintered compact of carbon of the carbon nanotube array sheet and silicon and/or titanium contained in the fixture sheet.

With this configuration, the sintered body includes a sintered compact containing carbon of the carbon nanotube array sheet and silicon and/or titanium contained in the fixture sheet, and therefore affinity between the carbon nanotube array sheet and the sintered body can be improved, and the carbon nanotube array sheet can be bonded reliably to the sintered body. Therefore, the CNT in the carbon nanotube array sheet can be reliably suppressed from dropping out from the fixture sheet.

The present invention [3] includes a carbon nanotube bonded sheet of [1] or [2] above, wherein an end portion of the carbon nanotube array sheet bonded to the sintered body is embedded in the sintered body.

With this configuration, the end portion of the carbon nanotube array sheet is embedded in the sintered body, and therefore the CNT in the carbon nanotube array sheet can be reliably suppressed from dropping from the fixture sheet even more.

The present invention [4] includes the carbon nanotube bonded sheet of any one of [1] to [3] above, wherein the carbon nanotube array sheet has an average bulk density of 50 mg/cm³ or more.

With this configuration, the carbon nanotube array sheet has an average bulk density of the above-described lower limit or more, and therefore thermal conductivity of the carbon nanotube array sheet can be improved, and also thermal conductivity of the carbon nanotube bonded sheet can be improved.

However, when the carbon nanotube array is allowed to grow on both sides of the substrate by chemical vapor deposition, it is difficult to set the average bulk density of the carbon nanotube array to the above-described lower limit or more.

Meanwhile, with the above-described configuration, the carbon nanotube array sheet removed from the growth substrate is bonded to the sintered body of the fixture sheet, and therefore the carbon nanotube array sheet can be densified after being removed from the growth substrate. Therefore, the average bulk density of the carbon nanotube array sheet can be set to the above-described lower limit or more.

The present invention [5] includes a method for producing a carbon nanotube bonded sheet, the method including the steps of: preparing a fixture sheet formed from a sintered body of an inorganic material; allowing vertically-aligned carbon nanotube to grow on a growth substrate; removing the vertically-aligned carbon nanotube from the growth substrate to form a carbon nanotube array sheet; disposing a metal thin film between the carbon nanotube array sheet and the fixture sheet; and calcining the carbon nanotube array sheet and the fixture sheet between which the metal thin film is disposed under vacuum or inert atmosphere.

With such a method, the metal thin film is disposed between the carbon nanotube array sheet removed from the growth substrate and the fixture sheet formed from a sintered body of an inorganic material, and thereafter they are calcined, which allows the carbon nanotube array sheet to be strongly bonded to the fixture sheet.

Therefore, the carbon nanotube bonded sheet including the carbon nanotube array sheet bonded to the sintered body of the fixture sheet can be produced efficiently with an easy method.

The present invention [6] includes a method for producing a carbon nanotube bonded sheet, the method including the steps of: preparing a resin sheet containing inorganic particles; allowing vertically-aligned carbon nanotube to grow on a growth substrate; removing the vertically-aligned carbon nanotube from the growth substrate to form a carbon nanotube array sheet; disposing the carbon nanotube array sheet on the resin sheet; and calcining the resin sheet on which the carbon nanotube array sheet is disposed under vacuum or inert atmosphere.

With such a method, the carbon nanotube array sheet removed from the growth substrate is disposed on the resin sheet containing inorganic particles, and thereafter calcined, which allows the inorganic particles to be formed into the sintered body to form the fixture sheet. Then, the carbon nanotube array sheet can be bonded to the sintered body of the fixture sheet.

Therefore, the carbon nanotube bonded sheet including the carbon nanotube array sheet bonded to the sintered body of the fixture sheet can be produced efficiently with an easy method.

The present invention [7] includes a method for producing a carbon nanotube bonded sheet, the method including the steps of: allowing vertically-aligned carbon nanotube to grow on a growth substrate; removing the vertically-aligned carbon nanotube from the growth substrate to form a carbon nanotube array sheet; applying a paste containing inorganic particles to the carbon nanotube array sheet; and calcining the carbon nanotube array sheet to which the paste is applied under vacuum or inert atmosphere.

With such a method, the paste containing inorganic particles is applied to the carbon nanotube array sheet removed from the growth substrate, and thereafter calcined, which allows the inorganic particles to be formed into the sintered body to form the fixture sheet. Then, the carbon nanotube array sheet can be bonded to the sintered body of the fixture sheet.

Therefore, the carbon nanotube bonded sheet including the carbon nanotube array sheet bonded to the sintered body of the fixture sheet can be produced efficiently with an easy method.

### Effects of the Invention

The carbon nanotube bonded sheet of the present invention can conform to subtle dents and bumps on the surface of an object and suppress dropping of the CNT.

With the method for producing a carbon nanotube bonded sheet of the present invention, the above-described carbon nanotube bonded sheet can be produced efficiently with an easy method.

### BRIEF DESCRIPTION OF THE DRAWINGS

[FIG. 1] FIG. 1A is a side view of a thermal conductive sheet as a first embodiment of the carbon nanotube bonded sheet of the present invention. FIG. 1B is a schematic diagram illustrating a state in which the thermal conductive sheet shown in FIG. 1A is disposed between the electronic component and the heat sink.
[FIG. 2] FIG. 2A illustrates an embodiment of a step of allowing vertically-aligned carbon nanotubes (VACNTs) to grow on a growth substrate, showing a step of forming a catalyst layer on a substrate. FIG. 2B shows, following FIG. 2A, heating a substrate to cause coagulation of the catalyst layer into a plurality of granular bodies. FIG. 2C shows, following FIG. 2B, a step of supplying a source gas to the plurality of granular bodies to allow growth of a plurality of carbon nanotubes to prepare VACNTs.
[FIG. 3] FIG. 3A illustrates a step of removing VACNTs, showing a step of cutting VACNTs from the growth substrate. FIG. 3B shows, following FIG. 3A, a step of removing the VACNTs from the growth substrate to form a carbon nanotube array sheet (CNT array sheet).
FIG. 3C is a perspective view of the CNT array sheet shown in FIG. 3B.
[FIG. 4] FIG. 4A illustrates a step of densifying the CNT array sheet shown in FIG. 3C, showing a step of accommodating the CNT array sheet in a heat resistant vessel. FIG. 4B shows, following FIG. 4A, a step of heating the CNT array sheet to densify the CNT array sheet. FIG. 4C illustrates a step of forming the metal thin film on the densified CNT array sheet shown in FIG. 4B, and a step of disposing on both front and back sides of the fixture sheet.
[FIG. 5] FIG. 5A illustrates a step of disposing the densified CNT array sheet shown in FIG. 4B on both front and back sides of the resin sheet. FIG. 5B illustrates a step of forming a paste layer by applying a paste on the densified CNT array sheet shown in FIG. 4B. FIG. 5C illustrates, following FIG. 5B, disposing the CNT array sheet on the surface of the paste layer.
[FIG. 6] FIG. 6 is a side view of the thermal conductive sheet as a second embodiment of the carbon nanotube bonded sheet of the present invention.
[FIG. 7] FIG. 7A illustrates a step of mechanically densifying the VACNTs shown in FIG. 2C, showing a step of disposing pressing plates so as to sandwich the VACNTs. FIG. 7B illustrates, following FIG. 7A, a step of compressing the VACNTs with the pressing plates.

### Description of the embodiments

The carbon nanotube bonded sheet of the present invention (hereinafter referred to as CNT bonded sheet) includes a fixture sheet formed from a sintered body of an inorganic material and a carbon nanotube array sheet bonded to the sintered body of the fixture sheet. The carbon nanotube array sheet bonded to the fixture sheet will suffice, and for example, it can be bonded to at least one of the front side and back side of the fixture sheet.

In the following, a thermal conductive sheet 1 as a first embodiment of the CNT bonded sheet of the present invention is described.

### 1. First embodiment

### (1) Configuration of thermal conductive sheet

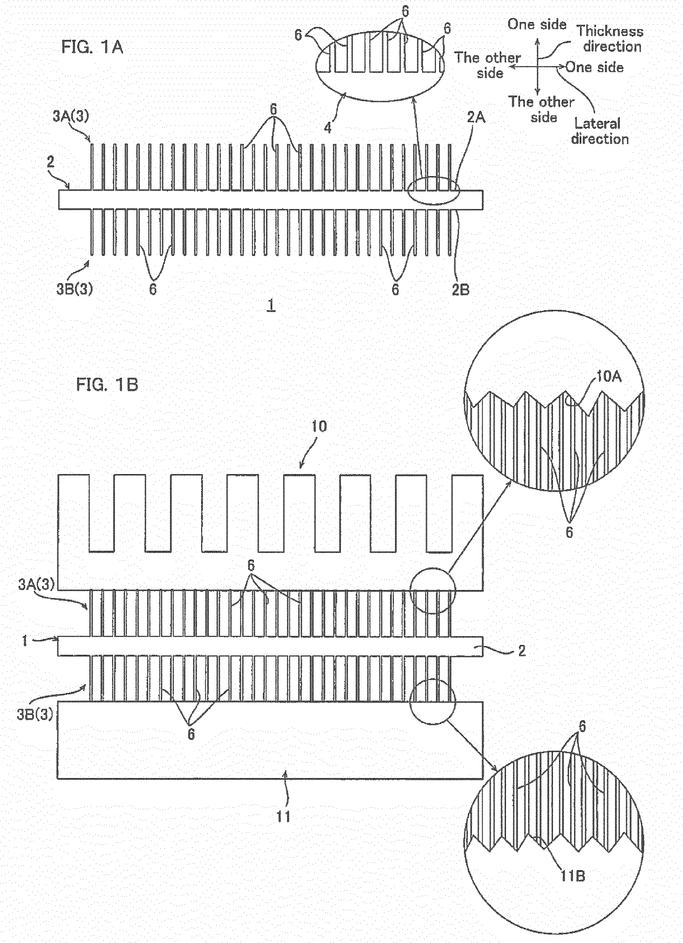

The thermal conductive sheet 1 (en example of CNT bonded sheet) includes, as shown in FIG. 1A, a fixture sheet 2, and two carbon nanotube array sheets 3 (hereinafter referred to as CNT array sheet 3).

The fixture sheet 2 has a sheet shape (flat plate shape), to be specific, the fixture sheet 2 has a predetermined thickness, extends in a surface direction orthogonal to its thickness direction (vertical direction and lateral direction), and has a flat front face 2A (one side in thickness direction) and a flat back face 2B (the other side in thickness direction).

The fixture sheet 2 has a thickness of, for example, 10 µm or more, preferably 50 µm or more, and for example, 500 µm or less, preferably 300 µm or less.

The fixture sheet 2 is formed from a sintered body of an inorganic material. To be specific, the fixture sheet 2 is a ceramic sheet formed by bonding of the inorganic material particles by sintering. In FIG. 1A, the sintered body of the inorganic material is shown as a sintered body 4.

Examples of the inorganic material include metals (for example, titanium, silicon, tungsten, etc.), inorganic oxides (for example, silica, alumina, titanium oxide, zinc oxide, magnesium oxide, etc.), inorganic nitrides (for example, aluminum nitride, boron nitride, silicon nitride, etc.), and inorganic carbides (for example, silicon carbide, titanium carbide, tungsten carbide, etc.). Such an inorganic material can be used singly, or can be used in combination of two or more.

Such an inorganic material is suitably selected in accordance with application of the thermal conductive sheet 1. In the first embodiment, inorganic carbide is used as the inorganic material, the case of which is described next. For the inorganic carbide, preferably, inorganic carbide including silicon and/or titanium, that is, silicon carbide and titanium carbide are used.

The fixture sheet 2 is electrically non-conductive, and the fixture sheet 2 has an electric resistance (conductive resistance) in the thickness direction at 25°C of, for example, 10³Ω or more, preferably 10⁴Ω or more, and for example, 10⁸Ω or less.

The fixture sheet 2 has a thermal conductivity in the thickness direction of, for example, 2W/(m·K) or more, preferably 5W/(m·K) or more.

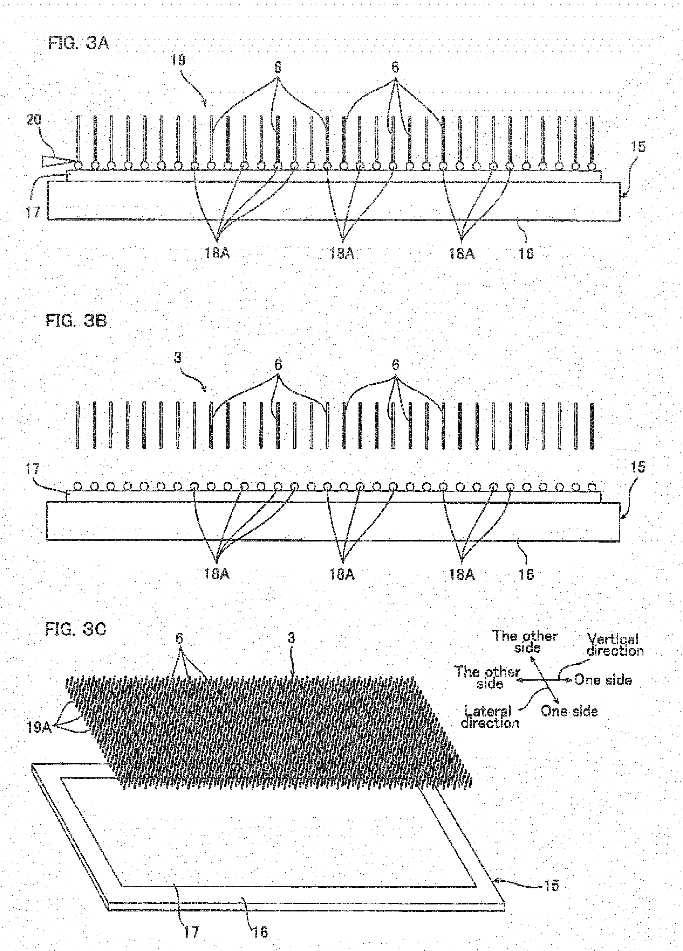

The CNT array sheet 3 is, as shown in FIG. 3C, removed from the growth substrate 15 (described later, ref: FIG. 3B), and is a carbon nanotube collected product formed into a sheet shape from a plurality of carbon nanotubes 6 (hereinafter referred to as CNT 6).

To be more specific, in the CNT array sheet 3, the plurality of CNTs 6 are aligned in the thickness direction of the CNT array sheet 3, and are arranged in the surface direction (vertical direction and lateral direction) continuously to form a sheet, without being continuous in the thickness direction.

That is, the carbon nanotube array sheet 3 (CNT array sheet 3) is formed to be a sheet by continuity of the plurality of carbon nanotubes 6 (CNT 6) aligned in a predetermined direction, the continuity being in a direction orthogonal to the alignment direction of the carbon nanotube 6.

In this manner, the CNT array sheet 3 keeps its form in a state where it is removed from the growth substrate 15 (described later) and the plurality of CNTs 6 are in contact with each other in the surface direction. The CNT array sheet 3 has flexibility. Of the plurality of CNTs 6, van der Waals force acts between CNTs 6 that are adjacent to each other.

The CNT 6 may be a single-walled carbon nanotube, double-walled carbon nanotube, or multi-walled carbon nanotube, and a multi-walled carbon nanotube is preferable. The plurality of CNTs 6 may include only one of the single-walled carbon nanotube, double-walled carbon nanotube, and multi-walled carbon nanotube, or may include two or more of the single-walled carbon nanotube, double-walled carbon nanotube, and multi-walled carbon nanotube.

The CNT 6 has an average external diameter of, for example, 1 nm or more, preferably 5 nm or more, and for example, 100 nm or less, preferably 50 nm or less, more preferably 20 nm or less.

The CNT 6 has an average length (size in average alignment direction) of, for example, 10 µm or more, preferably 50 µm or more, and for example, 1000 µm or less, preferably 500 µm or less, more preferably 200 µm or less. The average external diameter and the average length of CNT are measured, for example, by a known method such as electron microscope observation.

In the CNT array sheet 3, the plurality of CNTs 6 have an average bulk density of, for example, 10mg/cm³ or more, preferably 50mg/cm³ or more, more preferably 100mg/cm³ or more, and for example, 500mg/cm³ or less, preferably 300mg/cm³ or less, more preferably 200mg/cm³ or less. The average bulk density of the CNT 6 is calculated from, for example, the mass per unit area (weight per unit area: mg/cm²) and the average length of the carbon nanotubes (which is measured by SEM (from JEOL Corporation) or by a non-contact film thickness meter (from KEYENCE Corporation)).

The CNT array sheet 3 has a G/D ratio of, for example, 1 or more, preferably 2 or more, more preferably 5 or more, even more preferably 10 or more, and for example, 20 or less, preferably 15 or less.

The G/D ratio is, in Raman spectrum of the carbon nanotube, ratio of spectrum intensity of G-band, i.e., the peak observed near 1590 cm⁻¹, relative to spectrum intensity of D-band, i.e., the peak observed near the 1350cm⁻¹.

The D-band spectrum is derived from carbon nanotube deficiency, and the G-band spectrum is derived from in-plane vibration of 6-membered ring of carbon.

The CNT array sheet 3 has an electric resistance (conductive resistance) in the thickness direction of, at 25°C, for example, 1Ω or less, preferably 0.1Ω or less.

The CNT array sheet 3 has a thermal conductivity in the thickness direction of, for example, 1 W/(m·K) or more, preferably 2W/(m·K) or more, more preferably 10W/(m·K) or more, even more preferably 30W/(m·K) or more, and for example, 60W/(m·K) or less, preferably 40W/(m·K) or less.

As shown in FIG. 1A, the CNT array sheet 3 is supported by the fixture sheet 2 by being bonded to the inorganic material sintered body 4 at both of the front face 2A and back face 2B of the fixture sheet 2.

That is, of the two CNT array sheets 3, one is bonded to the front face 2A of the fixture sheet 2, and the other is bonded to the back face 2B of the fixture sheet 2, and they are disposed so as to sandwich the fixture sheet 2 in the thickness direction.

When the two CNT array sheets 3 are to be distinguished from each other, the CNT array sheet 3 bonded to the front face 2A of the fixture sheet 2 is named a first CNT array sheet 3A, and the CNT array sheet 3 bonded to the back face 2B of the fixture sheet 2 is named a second CNT array sheet 3B.

The fixture sheet 2-side end portion of the CNT array sheet 3 is embedded in and bonded to the sintered body 4 of the fixture sheet 2, and the non-fixture sheet 2-side end portion of the CNT array sheet 3 is a free end. That is, the end portion bonded to the sintered body 4 of the CNT array sheet 3 is embedded in the sintered body 4 of the fixture sheet 2.

To be more specific, the other side end portion of the first CNT array sheet 3A is embedded in and bonded to the sintered body 4 at the front face 2A of the fixture sheet 2, and one side end portion of the first CNT array sheet 3A is a free end. The one side end portion of the second CNT array sheet 3B is embedded in and bonded to the sintered body 4 at the back face 2B of the fixture sheet 2, and the other side end portion of the second CNT array sheet 3B is a free end. The thickness direction of the CNT array sheet 3 coincides with the thickness direction of the fixture sheet 2, and the CNTs 6 of the CNT array sheet 3 extend along the thickness direction of the fixture sheet 2.

Such a thermal conductive sheet 1 has an electric resistance (conductive resistance) in the thickness direction of, for example, 10³Ω or more, preferably 10⁴Ω or more, and for example, 10⁷Ω or less, preferably 10⁶Ω or less.

The thermal conductivity of the thermal conductive sheet 1 in the thickness direction is, for example, 1W/(m·K) or more, preferably 2W/(m·K) or more, more preferably 10W/(m·K) or more, even more preferably 25W/(m·K) or more, particularly preferably 50W/(m·K) or more, and for example, 300W/(m·K) or less, preferably 100W/(m·K) or less.

### (2) Method for producing a CNT bonded sheet

Next, description is given as to an embodiment of the method for producing the thermal conductive sheet 1 (an example of CNT bonded sheet).

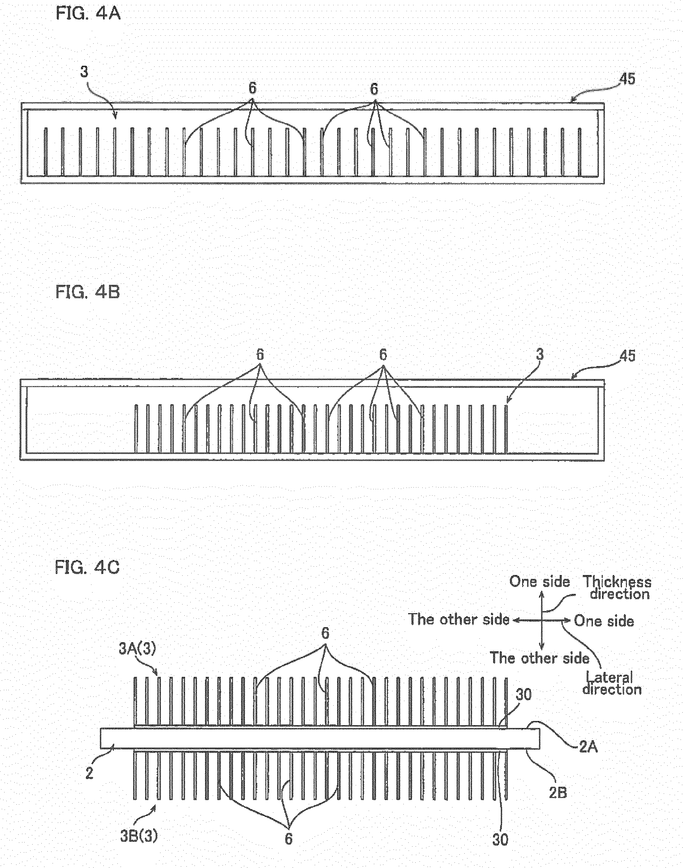

To produce the thermal conductive sheet 1, as shown in FIG. 4C, first, a fixture sheet 2 formed from the inorganic carbide sintered body is prepared (preparation step).

Also, separately from the fixture sheet 2, a CNT array sheet 3 is prepared.

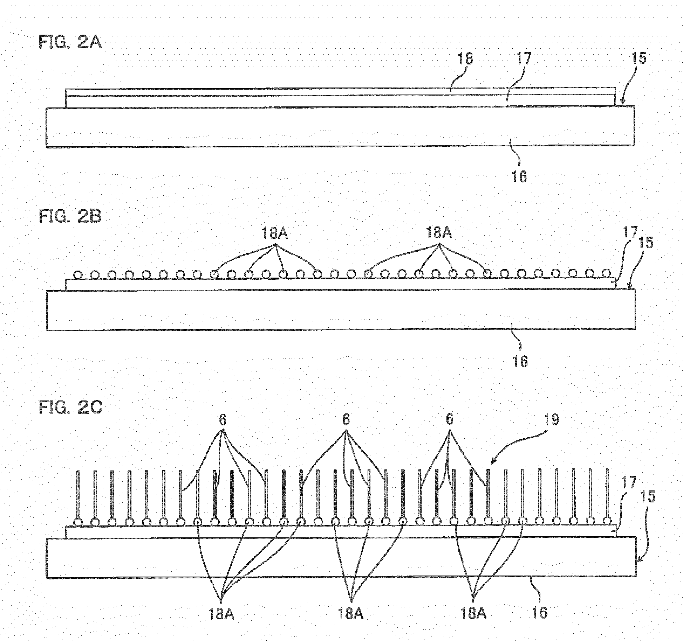

To prepare the CNT array sheet 3, as shown in FIG. 2A to FIG. 2C, for example, vertically-aligned carbon nanotubes 19 (in the following, referred to as VACNTs 19) are allowed to grow on the growth substrate 15 by chemical vapor deposition (CVD method) (CNT growth step).

To be specific, as shown in FIG. 2A, first, the growth substrate 15 is prepared. The growth substrate 15 is not particularly limited, and for example, a known substrate used for CVD method is used, and a commercially available product can be used.

Examples of the growth substrate 15 include silicon substrate, and a stainless steel substrate 16 on which a silicon dioxide film 17 is stacked, and preferably, the stainless steel substrate 16 on which the silicon dioxide film 17 is stacked is used. In FIG. 2A to FIG. 3C, the growth substrate 15 is the stainless steel substrate 16 on which the silicon dioxide film 17 is stacked.

Then, as shown in FIG. 2A, on the growth substrate 15, preferably on the silicon dioxide film 17, a catalyst layer 18 is formed. To form the catalyst layer 18 on the growth substrate 15, a film of metal catalyst is formed by a known film-forming method on the growth substrate 15 (preferably, silicon dioxide film 17).

Examples of the metal catalyst include iron, cobalt, and nickel, preferably, iron is used. Such a metal catalyst can be used singly, or can be used in combination of two or more. Examples of the film-forming method include vacuum deposition and sputtering, and preferably, vacuum deposition is used.

In this manner, the catalyst layer 18 is disposed on the growth substrate 15. When the growth substrate 15 is a stainless steel substrate 16 on which the silicon dioxide film 17 is stacked, the silicon dioxide film 17 and the catalyst layer 18 can be formed simultaneously by, for example, as described in Japanese Unexamined Patent Publication No. 2014-94856, applying a mixture solution in which a silicon dioxide precursor solution and a metal catalyst precursor solution are mixed on a stainless steel substrate 16, and thereafter causing phase separation in the mixture solution, and then drying.

Then, the growth substrate 15 on which the catalyst layer 18 is disposed is heated, as shown in FIG. 2B, for example, at 700°C or more and 900°C or less. In this manner, the catalyst layer 18 goes through coagulation to form a plurality of granular bodies 18A.

Then, a source gas is supplied to the heated growth substrate 15, as shown in FIG. 2C. The source gas contains a hydrocarbon gas with a number of carbon atoms of 1 to 4 (lower hydrocarbon gas). Examples of the hydrocarbon gas with carbon atoms of 1 to 4 include methane gas, ethane gas, propane gas, butane gas, ethylene gas, and acetylene gas, and preferably, acetylene gas is used.

The source gas can contain, as necessary, hydrogen gas, inert gas (for example, helium, argon, etc.), and water vapor.

The source gas is supplied for, for example, 1 minute or more, preferably 5 minutes or more, and for example, 60 minutes or less, preferably 30 minutes or less.

In this manner, the plurality of CNTs 6 are allowed to grow, originating from the plurality of granular bodies 18A. In FIG. 2C, for convenience, one CNT 6 is grown from the one granular body 18A, but it is not limited thereto, and a plurality of CNTs 6 can be grown from one granular body 18A.

Such a plurality of CNTs 6 extend on the growth substrate 15 so that they are substantially parallel to each other in the thickness direction (up-down direction) of the growth substrate 15. That is, the plurality of CNTs 6 are aligned orthogonal to the growth substrate 15 (vertically aligned).

In this manner, the VACNTs 19 grow on the growth substrate 15.

The VACNTs 19 include, as shown in FIG. 3C, a plurality of rows 19A arranged in lateral direction. In each of the rows 19A, the plurality of CNTs 6 are arranged linearly in vertical direction. In the VACNTs 19, the plurality of CNTs 6 are densified in the surface direction (vertical direction and lateral direction).

Then, as shown in FIG. 3A and FIG. 3B, the VACNTs 19 are removed from the growth substrate 15 (removal step).

To remove the VACNTs 19 from the growth substrate 15, for example, a cutting blade 20 is slid along the upper face of the growth substrate 15 to collectively cut the proximal end portion (growth substrate 15 side end portion) of the plurality of CNTs 6. The VACNTs 19 are separated from the growth substrate 15 in this manner.

Examples of the cutting blade 20 include known metal blades such as a cutter blade, and a razor, and preferably, a cutter blade is used.

Then, the separated VACNTs 19 are taken out, as shown in FIG. 3B, from the growth substrate 15. In this manner, the VACNTs 19 are removed from the growth substrate 15, and a CNT array sheet 3 is formed. By repeating the above-described steps, two CNT array sheets 3, to be specific, a first CNT array sheet 3A and a second CNT array sheet 3B are prepared.

Such a CNT array sheet 3 can be used as is as the thermal conductive sheet 1, but because of its relatively low average bulk density, in view of improvement in thermal conductivity, preferably it is densified (densifying step).

For densifying, for example, the CNT array sheet 3 can be heated (ref: FIG. 4A and FIG. 4B) or a volatile liquid can be supplied to the CNT array sheet 3.

To heat the CNT array sheet 3, for example, as shown in FIG. 4A, the CNT array sheet 3 is stored in a heat resistant vessel 45, and disposed in a heating furnace.

The heat resistant vessel 45 is a heat resistant vessel having a heat-resistant temperature of more than 2600°C, and examples thereof include known heat resistant vessels such as a carbon vessel made from carbon and a ceramic vessel made from ceramics. Of these heat resistant vessels, preferably, carbon vessel is used.

Examples of the heating furnace include a resistance heating furnace, induction heating furnace, and direct electric furnace, and preferably, the resistance heating furnace is used. The heating furnace may be a batch type, or a continuous type.

Then, an inert gas is supplied to the heating furnace to replace inside the heating furnace with an inert gas atmosphere. Examples of the inert gas include nitrogen and argon, and preferably, argon is used.

Then, the temperature in the heating furnace is increased at a predetermined temperature increase speed to the heating temperature, and thereafter it is allowed to stand for a predetermined time while the temperature is kept.

The temperature increase speed is, for example, 1°C/minute or more, preferably 5°C/minute or more, and for example, 40°C/minute or less, preferably 20°C/minute or less.

The heating temperature is, for example, 2600°C or more, preferably 2700°C or more, more preferably 2800°C or more. When the heating temperature is the above-described lower limit or more, the plurality of CNTs 6 can be reliably densified in the CNT array sheet 3.

The heating temperature can be less than the sublimation temperature of the CNT 6, preferably 3000°C or less. When the heating temperature is the above-described upper limit or less, sublimation of the CNT 6 can be suppressed.

The predetermined time can be, for example, 10 minutes or more, preferably 1 hour or more, and for example, 5 hours or less, preferably 3 hours or less.

The CNT array sheet 3 is preferably heated under no load (state where no load is applied to the CNT array sheet 3, that is, under atmospheric pressure). To heat the CNT array sheet 3 under no load, as shown in FIG. 4A, the CNT array sheet 3 is stored in the heat resistant vessel 45 so that the CNT array sheet 3 is spaced apart from the cover and the side wall of the heat resistant vessel 45.

The CNT array sheet 3 is heated in this manner. When the CNT array sheet 3 is heated, in the CNT array sheet 3, crystallinity of graphene forming the plurality of CNTs 6 improves, and the CNT 6 alignment (linearity) improves. Then, in the CNT array sheet 3, the CNTs 6 adjacent to each other gather together to form bundles while keeping their alignment (linearity) due to van der Waals force working between them.

In this manner, the CNT array sheet 3 is entirely thickened homogenously, and the CNT array sheet 3 is densified. Thereafter, the CNT array sheet 3 is cooled (for example, natural cooling) as necessary.

The CNT array sheet 3 after heating has a thickness of about the same as the thickness of the CNT array sheet 3 before heating, because the plurality of CNTs 6 are densified while keeping their alignment (linearity). To be more specific, the CNT array sheet 3 after heating has a thickness of, relative to the thickness of the CNT array sheet 3 before heating, for example, 95% or more and 105% or less, preferably 100%.

The CNT array sheet 3 after heating has a volume of, relative to the volume of the CNT array sheet 3 before heating, for example, 10% or more, preferably 30% or more, and for example, 70% or less, preferably 50% or less.

The CNT array sheet 3 after heating has a G/D ratio of, for example, 2 or more.

When a volatile liquid is supplied to the CNT array sheet 3, for example, the volatile liquid is sprayed over the CNT array sheet 3, or the CNT array sheet 3 is immersed in the volatile liquid.

Examples of the volatile liquid include water and an organic solvent. Examples of the organic solvent include lower (CI to 3) alcohols (for example, methanol, ethanol, propanol, etc.), ketones (for example, acetone, etc.), ethers (for example, diethylether, tetrahydrofuran, etc.), alkylesters (for example, ethyl acetate, etc.), halogenated aliphatic hydrocarbons (for example, chloroform, dichloromethane, etc.), and polar aprotic solvents (for example, N-methylpyrrolidone, dimethylformamide, etc.).

Of these volatile liquids, preferably, water is used. Such a volatile liquid can be used singly, or can be used in combination of two or more.

When the volatile liquid is supplied to the CNT array sheet 3, the volatile liquid is vaporized, and the plurality of CNTs 6 gathers together, which improves density of the CNT array sheet 3.

Such densifying treatment is performed at least once, and it can be repeated a plurality of times. The same densifying treatment can be repeated a plurality of times, and different types of densifying treatment can be performed in combination. For example, the above-described heating treatment singly can be repeated a plurality of times, or the above-described heating treatment can be performed in combination with the above-described liquid supply treatment.

In the CNT array sheet 3 after densification, the plurality of CNTs 6 have an average bulk density of, for example, 50mg/cm³ or more, an electric resistance (conductive resistance) in the thickness direction at 25°C of, for example, 1Ω or more, and a thermal conductivity in the thickness direction of, for example, 10W/(m·K) or more.

In the above-described manner, the fixture sheet 2 formed from the inorganic carbide sintered body, and two CNT array sheets 3 are prepared.

Then, as shown in FIG. 4C, a metal thin film 30 is disposed between the fixture sheet 2 and the CNT array sheet 3 (thin film disposing step). To dispose the metal thin film 30 between the fixture sheet 2 and the CNT array sheet 3, first, the metal thin film 30 is formed on the two CNT array sheets 3 (thin film forming step).

To be more specific, the metal thin film 30 is formed on the other side in thickness direction of the first CNT array sheet 3A, and the metal thin film 30 is formed on one side in thickness direction of the second CNT array sheet 3B.

To form the metal thin film 30 on the CNT array sheet 3, for example, metal is vapor deposited on the CNT array sheet 3. Examples of the metals include the above-described metals. Of such a metal, in view of affinity, preferably, the metal that is the same as the metal element contained in the inorganic carbide of the fixture sheet 2 is used. For example, when titanium carbide is used for the inorganic carbide of the fixture sheet 2, for the metal of the metal thin film 30, preferably, titanium is used, and when silicon carbide is used for the inorganic carbide of the fixture sheet 2, preferably, silicon is used for the metal thin film 30.

That is, for the combination of the inorganic carbide of the fixture sheet 2 and the metal of the metal thin film 30, preferably, a combination of titanium carbide and titanium, and a combination of silicon carbide and silicon are used.

Then, the CNT array sheet 3 is disposed on both front face 2A and back face 2B of the fixture sheet 2 so that the metal thin film 30 is brought into contact with the fixture sheet 2.

To be more specific, the first CNT array sheet 3A is disposed so that the metal thin film 30 of the first CNT array sheet 3A is brought into contact with the front face 2A of the fixture sheet 2, and the second CNT array sheet 3B is disposed so that the metal thin film 30 of the second CNT array sheet 3B is brought into contact with the back face 2B of the fixture sheet 2. In this manner, the first CNT array sheet 3A and the second CNT array sheet 3B are disposed so as to sandwich the fixture sheet 2 in the thickness direction, and the metal thin film 30 is disposed between the CNT array sheet 3 and the fixture sheet 2. The metal thin film 30 has a thickness of, for example, 5 nm or more and 1 µm or less.

Then, the fixture sheet 2 on which the CNT array sheet 3 is disposed (CNT array sheet 3 on which the metal thin film 30 is disposed and fixture sheet 2) is calcined under vacuum or inert atmosphere (calcining step).

To calcine such a fixture sheet 2, for example, the fixture sheet 2 on which the CNT array sheet 3 is disposed is placed in the above-described heating furnace. Then, the inside the heating furnace is allowed to be in a vacuum state by a known method (for example, vacuum pump, etc.), or replaced with the above-described inert gas atmosphere.

The pressure under vacuum is, for example, 100Pa or less, preferably 10Pa or less. For the inert gas, preferably, argon is used.

Then, the temperature in the heating furnace is increased to the calcining temperature, and thereafter the fixture sheet 2 is allowed to stand for a predetermined time while keeping the temperature.

The calcining temperature is the temperature at which the metal thin film 30 melts or more, and the less than the sublimation temperature of the CNT 6, and for example, 1000°C or more, preferably 1500°C or more, and for example, 2500°C or less, preferably 2000°C or less. The calcining time is, for example, I minute or more, preferably 5 minutes or more, and for example, 1 hour or less, preferably 30 minutes or less.

In this manner, the metal of the metal thin film 30 vapor deposited on the CNT array sheet 3 is allowed to react with carbon of the CNT 6 of the CNT array sheet 3 to produce inorganic carbide.

To be more specific, when the inorganic carbide of the fixture sheet 2 is silicon carbide and the metal of the metal thin film 30 is silicon, carbon of the CNT 6 of the CNT array sheet 3 reacts with silicon to produce silicon carbide (inorganic carbide), and silicon carbide (inorganic carbide) is sintered, as shown in FIG. 1A, so as to be integrated with the silicon carbide (inorganic carbide) sintered body 4 of the fixture sheet 2, thereby bonding the CNT 6 with the fixture sheet 2.

Therefore, the CNT 6 of the CNT array sheet 3 is strongly bonded to the sintered body 4 by silicon carbide (inorganic carbide) produced by the reaction.

In this manner, the end portion of the CNT array sheet 3 (CNT 6) is embedded in and bonded to the sintered body 4. Then, the CNT array sheet 3 is supported by the fixture sheet 2.

To be more specific, the other side end portion of the CNT 6 of the first CNT array sheet 3A is embedded in and bonded to the sintered body 4 at the front face 2A of the fixture sheet 2, and one side end portion of the CNT 6 of the second CNT array sheet 3B is embedded in and bonded to the sintered body 4 at the back face 2B of the fixture sheet 2.

Thereafter, by cooling, the thermal conductive sheet 1 is produced.

When the metal thin film 30 is formed from silicon in the above-described manner, the CNT array sheet 3 is bonded to the sintered body 4 by reaction sintering involving reaction between carbon of the CNT 6 and silicon in the calcining step. In this case, the sintered body 4 contains silicon carbide (inorganic carbide) as the reaction product of carbon of the CNT array sheet 3 and silicon. That is, the sintered body 4 includes a sintered compact of carbon of the CNT array sheet 3 and silicon of the fixture sheet 2.

When the inorganic carbide of the fixture sheet 2 is titanium carbide and the metal thin film 30 is formed from titanium, in the above-described calcining step, carbon of the CNT 6 of the CNT array sheet 3 and titanium of the metal thin film 30 are allowed to react to produce titanium carbide, and titanium carbide is sintered so as to be integrated with the titanium carbide sintered body 4 of the fixture sheet 2, thereby bonding the CNT 6 with the fixture sheet 2.

That is, in the case when the metal thin film 30 is formed from titanium as well, the CNT array sheet 3 is bonded to the sintered body 4 by reaction sintering involving reaction between carbon of the CNT 6 and titanium. In this case, the sintered body 4 contains titanium carbide (inorganic carbide) as reaction product of carbon of the CNT array sheet 3 and titanium. That is, the sintered body 4 includes a sintered compact of carbon of the CNT array sheet 3 and titanium contained in the fixture sheet 2.

### (3) Embodiment of thermal conductive sheet use

Such a thermal conductive sheet 1 is disposed, as a TIM, as shown in FIG. 1B, for example, between the electronic component 11 (object) and a heat release member 10 (object) in the thickness direction and used.

Examples of the electronic component 11 include a semiconductor element (IC (integrated circuit) chip, etc.), light-emitting diode (LED), high output laser oscillation element, high output lamp, and power semiconductor element.

Examples of the heat release member 10 include a heat sink and heat spreader.

On the surface 11B of the electronic component 11, and on the surface 10A of the heat release member 10, subtle dents and bumps (surface roughness) are formed. They have a surface roughness Rz (10-point average roughness in accordance with JIS B0601-2013) of, for example, 1 µm or more and 10 µm or less.

In the thermal conductive sheet 1, the plurality of CNTs 6 of the first CNT array sheet 3A conforms to the subtle dents and bumps of the surface 10A of the heat release member 10 and are stably in contact with the surface 10A of the heat release member 10. The plurality of CNTs 6 of the second CNT array sheet 3B conform to the subtle dents and bumps of the surface 11B of the electronic component 11, and are stably in contact with the surface 11B of the electronic component 11.

Therefore, when the electronic component 11 generates heat, heat from the electronic component 11 is conducted to the heat release member 10 through the second CNT array sheet 3B, fixture sheet 2, and first CNT array sheet 3A in sequence.

### (4) Operations and effects

The thermal conductive sheet 1 includes, as shown in FIG. 1B, the CNT array sheet 3. Therefore, when the thermal conductive sheet 1 is brought into contact with an object (for example, heat release member 10 and electronic component 11), the plurality of CNTs 6 of the CNT array sheet 3 can be allowed to conform to subtle dents and bumps of the surface of the object.

The CNT array sheet 3 is bonded, as shown in FIG. 1A, to the sintered body 4 of the fixture sheet 2. Therefore, the CNT 6 of the CNT array sheet 3 can be suppressed from dropping from the fixture sheet 2.

The sintered body 4 includes a sintered compact of carbon of the CNT array sheet 3 and silicon and/or titanium contained in the fixture sheet 2. Therefore, affinity between the CNT array sheet 3 and the sintered body 4 can be improved, and the CNT array sheet 3 and the sintered body 4 can be bonded reliably. As a result, the CNT 6 of the CNT array sheet 3 can be reliably suppressed from dropping from the fixture sheet 2.

The end portion of the CNT array sheet 3 is embedded in the sintered body 4. Therefore, the CNT 6 of the CNT array sheet 3 can be reliably suppressed from dropping from the fixture sheet 2 even more.

The CNT array sheet 3 has an average bulk density of 50mg/cm³ or more. Therefore, thermal conductivity of the CNT array sheet 3 can be improved, and furthermore, thermal conductivity of the thermal conductive sheet 1 can be improved.

The CNT array sheet 3 removed from the growth substrate 15 is bonded to the sintered body 4 of the fixture sheet 2, and therefore the CNT array sheet 3 can be densified after removing from the growth substrate 15. Therefore, average bulk density of the CNT array sheet 3 can be set to the above-described lower limit or more.

The metal thin film 30 is formed on the CNT array sheet 3 removed from the growth substrate 15, and thereafter the CNT array sheet 3 is disposed on the fixture sheet 2 formed from the inorganic material sintered body 4, and thereafter they are calcined. This allows the CNT array sheet 3 to strongly bond with the fixture sheet 2.

Therefore, the thermal conductive sheet 1 including the CNT array sheet 3 bonded to the sintered body 4 of the fixture sheet 2 can be produced efficiently with an easy method.

In the above-described method for producing a thermal conductive sheet, in the thin film disposing step, the metal thin film 30 is formed on the CNT array sheet 3, and the CNT array sheet 3 is disposed on the fixture sheet 2. However, it is not limited thereto, and the metal thin film 30 can be formed on the fixture sheet 2, and thereafter the CNT array sheet 3 can be disposed on the metal thin film 30. In this manner as well, the metal thin film 30 can be disposed between the CNT array sheet 3 and the fixture sheet 2.

### 2. Second embodiment

In the first embodiment, as shown in FIG. 4C, the fixture sheet 2 formed from the sintered body 4 of the inorganic material is prepared, and the CNT array sheet 3 is disposed on the fixture sheet 2, and thereafter calcined to produce the thermal conductive sheet 1. However, the present invention is not limited to such a method for producing the thermal conductive sheet.

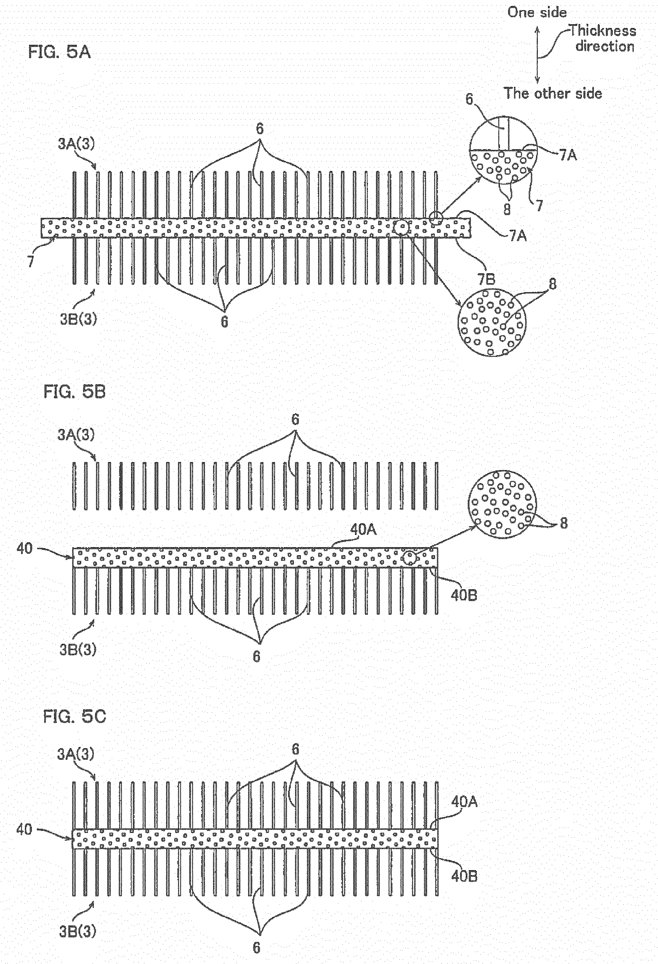

In the second embodiment, as shown in FIG. 5A, a resin sheet 7 containing the inorganic particles 8 is prepared, and a CNT array sheet 3 is disposed on the resin sheet 7, and thereafter they are calcined to produce a thermal conductive sheet 1. In the second embodiment, the same reference numerals are given to those members that are the same as those in the above-described first embodiment, and description thereof is omitted.

To be more specific, as shown in FIG. 5A, first, the resin sheet 7 containing the inorganic particles 8 is prepared.

The resin sheet 7 has a sheet shape (flat plate shape), and has a flat front face 7A (one side in thickness direction) and a flat back face 7B (the other side in thickness direction). The resin sheet 7 is formed from resin material. That is, the resin sheet 7 contains the resin material and inorganic particles 8. Examples of the resin material include thermosetting resin and thermoplastic resin.

The thermosetting resin is a cured product (cured thermosetting resin), and for example, epoxy resin, polyimide resin, phenol resin, urea resin, melamine resin, unsaturated polyester resin, and thermosetting elastomer (for example, vulcanized rubber, silicone rubber, acrylic rubber, etc.) are used.

Examples of the thermoplastic resin include polyester (for example, polyethylene terephthalate, etc.), polyolefin (for example, polyethylene, polypropylene, etc.), polyamide, polystyrene, polyvinyl chloride, polyvinyl alcohol (PVA), polyvinylidene chloride, polyacrylonitrile, polyurethane, fluorine polymer (for example, polytetrafluoroethylene (PTFE), polyvinyl fluoride, polyvinylidene fluoride, etc.), thermoplastic elastomer (for example, olefin elastomer (for example, ethylene-propylene rubber, ethylene-propylene-diene rubber, etc.), styrene elastomer, vinyl chloride elastomer, etc.).

Of these resin materials, preferably, thermoplastic resin, and more preferably, PVA and fluorine polymer, particularly preferably, PVA is used. Such a resin material can be used singly, or can be used in combination of two or more.

The resin sheet 7 has a thickness of, for example, 5 µm or more, preferably 10 µm or more, and for example, 300 µm or less, preferably 100 µm or less.

The inorganic particles 8 are particles formed from the above-described inorganic material. The inorganic particles 8 can be formed from one type of inorganic material particles, and can be formed from two or more types of inorganic material particles.

The inorganic particles 8 have an average primary particle size of, for example, 0.1 µm or more, preferably 1 µm or more, and for example, 20 µm or less, preferably 10 µm or less.

The inorganic particles 8 are contained in an amount relative to a total amount of the resin sheet 7 of, for example, 5 mass% or more, preferably 10 mass% or more, and for example, 50 mass% or less, preferably 40 mass% or less.

Then, the CNT array sheet 3 prepared in the same manner as in the first embodiment is disposed on both the front face 7A and the back face 7B of the resin sheet 7. Then, the resin sheet 7 on which the CNT array sheet 3 is disposed is calcined under vacuum or inert atmosphere in the same manner as in the first embodiment (calcining step).

Then, the resin material of the resin sheet 7 is burned, and the inorganic particles 8 are brought into contact with each other, and the resin sheet 7-side end portion of the CNT array sheet 3 is brought into contact with the inorganic particles 8.

Then, the inorganic particles 8 contacting each other are sintered, and the CNT 6 of the CNT array sheet 3 and the inorganic particles 8 are sintered. In this manner, the inorganic particles 8 are formed into a sintered body 4, the fixture sheet 2 is formed, and the end portion of the CNT array sheet 3 (CNT 6) is bonded to the sintered body 4.

To be more specific, when the inorganic particles 8 are formed from metal and/or inorganic carbide, the CNT 6 of the CNT array sheet 3 is embedded in and bonded to the sintered body 4 in the same manner as in the first embodiment by reaction sintering involving reaction between carbon of the CNT 6 and metal and/or inorganic carbide. In this case, the sintered body 4 contains a sintered body of metal and inorganic carbide, or consists of a sintered body of inorganic carbide.

When the inorganic particles 8 are formed from inorganic oxide and/or inorganic nitride, the CNT 6 of the CNT array sheet 3 are physically embedded in and bonded in the sintered body 4 along with sintering of the inorganic particles 8 without reaction with the inorganic particles 8. In this case, the sintered body 4 does not contain the inorganic carbide sintered body, but contains inorganic oxide and/or inorganic nitride sintered body.

In this manner, the two CNT array sheets 3 are embedded in and bonded to the sintered body 4 of the inorganic material in the same manner as in the first embodiment at both front face 2A and back face 2B of the fixture sheet 2, and supported by the fixture sheet 2.

In the thermal conductive sheet 1 of the second embodiment, the range of the electric resistance (conductive resistance) in thickness direction is the same as the range of the electric resistance in the thickness direction of the above-described thermal conductive sheet 1, and the range of the thermal conductivity is the same as the range of the above-described thermal conductivity of the thermal conductive sheet 1.

With such a second embodiment, the CNT array sheet 3 removed from the growth substrate 15 is disposed on the resin sheet 7 containing the inorganic particles 8, as shown in FIG. 5A, and thereafter calcined to form the sintered body 4 from the inorganic particles 8. In this manner, as shown in FIG. 1A, the fixture sheet 2 can be formed, and the CNT array sheet 3 can be bonded to the sintered body 4 of the fixture sheet 2.

Therefore, the thermal conductive sheet 1 including the CNT array sheet 3 bonded to the sintered body 4 of the fixture sheet 2 can be produced efficiently with an easy method.

Such a second embodiment also achieves the same operations and effects as the above-described first embodiment.

### 3. Third embodiment

Next, description is given as to the third embodiment with reference to FIG. 5B and FIG. 5C. The same members as those in the above-described first embodiment and second embodiment are given the same reference numerals, and description thereof is omitted.

In the above-described second embodiment, the resin sheet 7 containing the inorganic particles 8 is prepared, and the CNT array sheet 3 is disposed on both sides of the resin sheet 7, and thereafter the resin sheet 7 is heated to sinter the inorganic particles 8 to produce the thermal conductive sheet 1. However, the present invention is not limited to such a method for producing the thermal conductive sheet.

In the third embodiment, first, as shown in FIG. 5B, a paste containing the inorganic particles 8 is prepared (paste preparation step).

To be specific, the paste contains the above-described resin material and inorganic particles 8. To prepare such a paste, the inorganic particles 8 are dispersed in the resin solution.

The inorganic particle 8 content relative to a total amount of the paste is, for example, 5 mass% or more, preferably 10 mass% or more, and for example, 50 mass% or less, preferably 40 mass% or less.

The resin solution is a solution in which the above-described resin material is dissolved in a solvent (for example, water, organic solvent, etc.). For the resin material, preferably, thermoplastic resin, more preferably, PVA is used.

Then, a paste is applied on one side in the thickness direction of the second CNT array sheet 3B (CNT array sheet 3) prepared in the same manner as in the above-described first embodiment to form a paste layer 40 (application step). Therefore, the paste layer 40 contains the resin material and inorganic particles 8.

The paste layer 40 has a thickness of, for example, 10 µm or more, preferably 20 µm or more, and for example, 3 mm or less, preferably 200 µm or less, more preferably 100 µm or less.

Then, as shown in FIG. 5C, the first CNT array sheet 3A (CNT array sheet 3) is disposed on the front face 40A (one side face in thickness direction) of the paste layer 40.

In this manner, the paste layer 40 is sandwiched between the first CNT array sheet 3A and the second CNT array sheet 3B. In other words, the CNT array sheet 3 (first CNT array sheet 3A and second CNT array sheet 3B) is disposed on both sides of the front face 40A and the back face 40B of the paste layer 40.

Then, the paste layer 40 (CNT array sheet 3 on which paste is applied) on which the CNT array sheet 3 is disposed is heated under vacuum or inert atmosphere to calcine the inorganic particles 8 (calcining step). The range of the calcining temperature and calcining time are the same as those in the above-described first embodiment.

In this case as well, the resin material of the resin sheet 7 is burned, and the inorganic particles 8 are brought into contact with each other, and the resin sheet 7-side end portion of the CNT array sheet 3 is brought into contact with the inorganic particles 8. Then, the inorganic particles 8 contacting each other are sintered, and the CNT 6 of the CNT array sheet 3 are embedded in and bonded to the sintered body 4.

That is, the paste containing the inorganic particles 8 is applied on the CNT array sheet 3 removed from the growth substrate 15, and thereafter calcined to form the inorganic particles 8 into the sintered body 4. In this manner, the fixture sheet 2 can be formed, and the CNT array sheet 3 can be bonded to the sintered body 4 of the fixture sheet 2.

Therefore, the thermal conductive sheet 1 including the CNT array sheet 3 bonded to the sintered body 4 of the fixture sheet 2 can be produced efficiently with an easy method.

The third embodiment also achieves the same operations and effects as the above-described first embodiment and the second embodiment.

### 4. Modified example

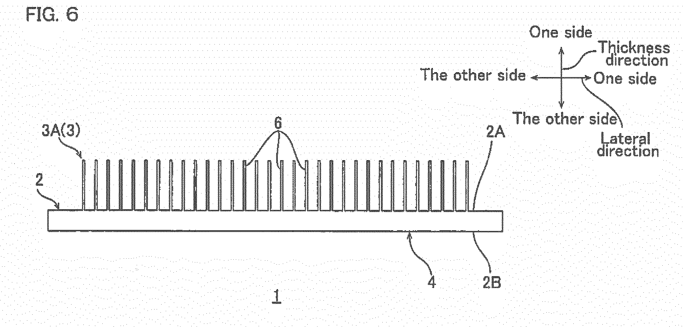

In the first embodiment and the second embodiment, the thermal conductive sheet 1 includes the CNT array sheet 3 bonded to both front face 2A and back face 2B of the fixture sheet 2, but it is not limited thereto. As shown in FIG. 6, the thermal conductive sheet 1 can include the CNT array sheet 3 bonded to the sintered body 4 of the fixture sheet 2 on at least one side of the front face 2A and back face 2B of the fixture sheet 2.

In the first embodiment and the second embodiment, the CNT array sheet 3 after densifying treatment is used for production of the thermal conductive sheet 1, but it is not limited thereto, and the CNT array sheet 3 can be removed from the growth substrate 15, and thereafter can be used for production of the thermal conductive sheet 1 without densifying treatment.

In this case, the CNT array sheet 3 is bonded to the sintered body 4 of the fixture sheet 2 and also densified at the same time in the calcining step. The plurality of CNTs 6 of the CNT array sheet 3 has an average bulk density of, for example, 50mg/cm³ or more.

In the first embodiment and the second embodiment, examples of the densifying treatment of the CNT array sheet 3 included heating and liquid supplying, but the CNT array sheet 3 densification is not limited thereto, and the CNT array sheet 3 can be densified by mechanical compression.

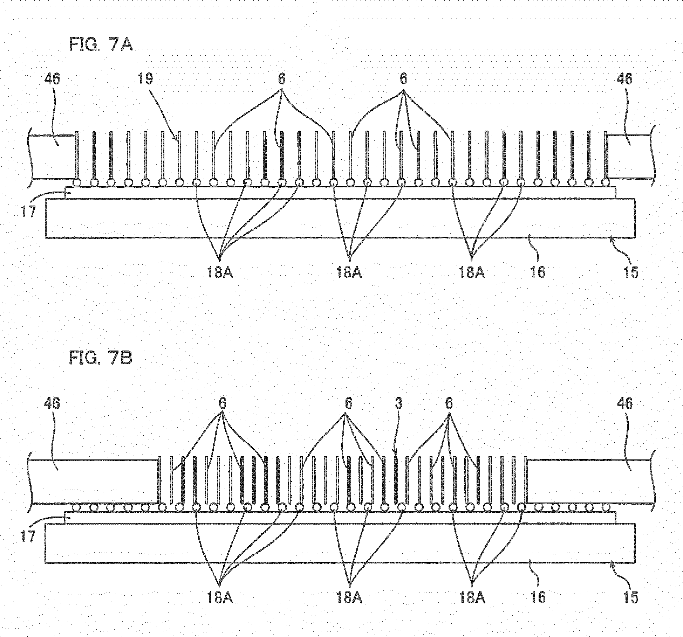

For example, as shown in FIG. 7A and FIG. 7B, the VACNTs 19 on the growth substrate 15 are compressed by two pressing plates 46 to prepare a densified CNT array sheet 3.

To be more specific, the two pressing plates 46 are disposed so as to sandwich the VACNTs 19, and thereafter they are slid close to compress the VACNTs 19. Then, the plurality of CNTs 6 of the VACNTs 19 are separated from the corresponding granular body 18A, and compressed to be brought into contact with each other.

The VACNTs 19 can be separated from the growth substrate 15 in this manner as well, and the densified CNT array sheet 3 can be prepared.

The fixture sheet 2 may contain graphite produced by graphitizing the above-described resin material in the calcining step. In this case, the graphite content relative to a total amount of the fixture sheet 2 is, for example, 10 mass% or more and 50 mass% or less.

In the configuration of the first embodiment to third embodiment, the fixture sheet 2 is electrically non-conductive, and the thermal conductive sheet 1 is an electrically non-conductive sheet, but it is not limited thereto, and the fixture sheet 2 can be formed to have electroconductivity, and the thermal conductive sheet 1 can be made into an electroconductive sheet.

When the thermal conductive sheet 1 is an electroconductive sheet, inorganic fine particles can be dispersed in the volatile liquid supplied in the densifying treatment of the CNT array sheet 3.

Examples of the inorganic fine particles include carbon fine particles (for example, carbon black, amorphous carbon, etc.), metal fine particles, and electroconductive ceramic fine particles. Such inorganic fine particles can be used singly, or can be used in combination of two or more.

In this case, inorganic fine particles are attached to the CNT array sheet 3 homogeneously. In this manner, suitable demanded characteristics can be given to the CNT array sheet 3 depending on the application of the thermal conductive sheet 1.

In the first embodiment to third embodiment, description is given as to the case where the CNT bonded sheet is the thermal conductive sheet 1, but the application of the CNT bonded sheet is not limited to the thermal conductive sheet. Examples of the CNT bonded sheet application include an adhesive sheet, vibration isolator, and heat insulating material.

These modified examples also achieve the same operations and effects as the above-described first to third embodiments. The first embodiment to third embodiment, and modified example can be suitably combined.

### Examples

The present invention is further described in detail based on EXAMPLES below. But the present invention is not limited to these Examples. The specific numerical values of mixing ratio (content), physical property value, and parameter used in the description below can be replaced with the upper limit values (numerical values defined with "or less" or "below") or lower limit values (numerical values defined with "or more" or "more than") of the corresponding numerical values of mixing ratio (content), physical property value, and parameter described in "DESCRIPTION OF EMBODIMENTS" above.

### (Example 1)

A silicon dioxide film was stacked on the surface of the stainless steel-made growth substrate (stainless steel substrate), and thereafter iron was vapor deposited as a catalyst layer on the silicon dioxide film.

Then, the growth substrate was heated to a predetermined temperature, and a source gas (acetylene gas) was supplied to the catalyst layer. In this manner, the VACNTs having a rectangular shape in plan view was formed on the growth substrate.

In the VACNTs, the plurality of CNTs extend in substantially parallel to each other, and aligned (vertical alignment) orthogonal to the growth substrate. The CNT is a multi-walled carbon nanotube, has an average external diameter of about 12 nm, and has an average length of about 80µm. The VACNTs have a bulk density of about 50mg/cm³.

Then, the cutter blade (cutting blade) was shifted along the growth substrate, and the VACNTs was cut out from the growth substrate to prepare the CNT array sheet.

Then, the CNT array sheet was accommodated in a heat resistant carbon vessel, and the carbon vessel was disposed in a resistance heating furnace (high temperature heating furnace).

Then, inside the resistance heating furnace was replaced with an argon atmosphere, and thereafter the temperature was increased at 10°C/min to 2800°C, and kept at 2800°C for 2 hours. In this manner, the CNT array sheet was densified, and thereafter cooled naturally to room temperature.

The densified CNT array sheet had a bulk density of about 100mg/cm³, and the CNT array sheet had an electric resistance (conductive resistance) in the thickness direction at 25°C of 0.1Ω, and the CNT array sheet had a thermal conductivity in the thickness direction of about 30W/(m·K).

Then, in the same manner as described above, two densified CNT array sheets were prepared.

Then, a silicon thin film (metal thin film) having a thickness of 20 nm is formed on one side of the two CNT array sheets by vapor deposition.

Then, a ceramic sheet (fixture sheet) formed from a sintered body of silicon carbide having a thickness of 100µm was prepared.

Then, the CNT array sheet was disposed on both front and back sides of the fixture sheet so that the silicon thin film was brought into contact with the ceramic sheet.

Then, the ceramic sheet on which the CNT array sheet was disposed was placed in a resistance heating furnace (high temperature heating furnace), and heated in an inert gas atmosphere at 1700°C for 15 minutes.

In this manner, carbon of the CNT and vapor deposited silicon were allowed to react to produce silicon carbide, and silicon carbide and the ceramic sheet were bonded by sintering. Thereafter, cooling was conducted, thereby producing a thermal conductive sheet.

### (Example 2)

A resin sheet formed from PVA and in which silicon particles (inorganic particles) were dispersed was prepared. The silicon particles had an average primary particle size of 2 µm, the silicon particle content relative to a total amount of the resin sheet was 20 mass%. The PVA content relative to a total amount of the resin sheet was 80 mass%.

Then, the CNT array sheet prepared in the same manner as in Example 1 was disposed on both front and back sides of the resin sheet. Then, the resin sheet on which the CNT array sheet was disposed was disposed in a resistance heating furnace (high temperature heating furnace), and heated in an inert gas atmosphere at 1700°C for 15 minutes.

In this manner, PVA of the resin sheet is burned, and at the same time, carbon of the CNT and silicon particles of the resin sheet were allowed to react to produce silicon carbide, and silicon carbide and silicon particles formed a sintered body, thereby forming a fixture sheet. That is, the fixture sheet contained a sintered body of silicon carbide and silicon. The fixture sheet had a thickness of 100µm.

Thereafter, cooling was conducted, thereby producing a thermal conductive sheet.

### (Example 3)

A paste was prepared by dispersing silicon particles (inorganic particles) in a PVA solution (resin solution, PVA concentration: 10 mass%) in which PVA was dissolved in water (solvent).

The silicon particles had an average primary particle size of 2µm, and the silicon particle content relative to the total amount of the paste was 20 mass%. The PVA content relative to a total amount of the paste was 80 mass%.

Then, of the two CNT array sheets prepared in the same manner as in Example 1, the paste was applied to one of the CNT array sheets to form a paste layer having a thickness of about 2 mm. Then, the other CNT array sheet was disposed on the paste layer so that the paste layer was sandwiched between the two CNT array sheets.

Thereafter, the paste layer on which the CNT array sheet was disposed was disposed in a resistance heating furnace (high temperature heating furnace), heating was conducted in an inert gas atmosphere at 1700°C for 15 minutes. Thereafter, cooling was conducted, thereby producing a thermal conductive sheet. The fixture sheet had a thickness of 100µm.

### (Example 4)

A thermal conductive sheet was produced in the same manner as in Example 2, except that a resin sheet formed from PVA and in which silicon nitride particles (inorganic particles) were dispersed was prepared. The fixture sheet of the thermal conductive sheet had a thickness of 100µm.

### (Comparative Example 1)

A silicon dioxide film was stacked on both front and back sides of a stainless steel-made growth substrate, and thereafter iron was vapor deposited as a catalyst layer on a silicon dioxide film.

Then, the growth substrate was heated to a predetermined temperature, and a source gas (acetylene gas) was supplied to the catalyst layer. In this manner, VACNTs having a rectangular shape in plan view were formed on both front and back sides of the substrate. In the VACNTs, the CNT had an average external diameter, an average length, and a bulk density that are the same as those of Example 1.

Then, the growth substrate on which VACNTs were disposed on both sides thereof was used as a thermal conductive sheet.

### <Evaluation>

### (1) Thermal conductivity

The thermal conductive sheet produced in Examples and Comparative Examples was subjected to measurement of thermal resistance with a thermal resistance measurement device (trade name: T3Ster DynTIM Tester, manufactured by Mentor Graphics Corp.). Then, the thickness of the thermal conductive sheet was changed, and the thermal resistance was measured at several points (for example, 3 points), and the thermal conductive sheet thickness and the measured thermal resistance were plotted. Based on the plotting, thermal conductivity of the thermal conductive sheet was calculated. The results are shown in Table 1.

### (2) Electric resistance

The thermal conductive sheet produced in Examples and Comparative Examples was subjected to measurement of electric resistance in thickness direction with an electric resistance measurement device (trade name: resistivity chamber, manufactured by ADC CORPORATION). The results are shown in Table 1.

### (3) Adhesive strength test

A pressure sensitive adhesive tape was bonded to the CNT array sheet from the opposite side from the fixture sheet in the thermal conductive sheet produced in Examples, and thereafter the pressure sensitive adhesive tape was removed.

A pressure sensitive adhesive tape was bonded to the VACNTs from the opposite side from the growth substrate in the thermal conductive sheet produced in Comparative Example, and thereafter the pressure sensitive adhesive tape was removed.

Then, the adhesive strength was evaluated based on the following criteria. The results are shown in Table 1.

GOOD: obvious separation of the CNT array sheet (VACNTs) from the fixture sheet (growth substrate) was not seen.

BAD: obvious separation of the CNT array sheet (VACNTs) from the fixture sheet (growth substrate) was seen.

**Table I**

| no. | Example 1 | Example 2 | Example 3 | Example 4 | Comparative example I |
|---|---|---|---|---|---|
| Thermal conductivity [W/(m·K)] | 30 | 30 | 20 | 15 | 6 |
| Electric resistance in thickness direction [Ω] | 10⁴∼10⁵ | 10³∼10⁴ | 10⁴∼10⁵ | 10⁵∼10⁶ | 10⁶ |
| Adhesive strength | GOOD | GOOD | GOOD | GOOD | BAD |

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The CNT bonded sheet can be applied to various industrial products, and for example, can be used as a thermal conductive material, adhesive sheet, vibration isolator, and heat insulating material. The method for producing a CNT bonded sheet can be suitably used for production of a CNT bonded sheet used for various industrial products.

### Description of reference numerals

- 1: thermal conductive sheet
- 2: fixture sheet
- 3: CNT array sheet
- 4: sintered body
- 6: CNT
- 7: resin sheet
- 8: inorganic particles
- 15: growth substrate
- 19: VACNTs

## Claims

1. A carbon nanotube bonded sheet comprising a fixture sheet formed from a sintered body of an inorganic material, and
a carbon nanotube array sheet bonded to the sintered body of the fixture sheet.

2. The carbon nanotube bonded sheet of Claim 1, wherein
the inorganic material contains silicon and/or titanium, and
the sintered body includes a sintered compact of carbon of the carbon nanotube array sheet and silicon and/or titanium contained in the fixture sheet.

3. The carbon nanotube bonded sheet of Claim 1, wherein
an end portion of the carbon nanotube array sheet bonded to the sintered body is embedded in the sintered body.

4. The carbon nanotube bonded sheet of Claim 1, wherein
the carbon nanotube array sheet has an average bulk density of 50mg/cm³ or more.

5. A method for producing a carbon nanotube bonded sheet, the method comprising the steps of:
preparing a fixture sheet formed from a sintered body of an inorganic material,
allowing vertically-aligned carbon nanotube to grow on a growth substrate,
removing the vertically-aligned carbon nanotube from the growth substrate to form a carbon nanotube array sheet,
disposing a metal thin film between the carbon nanotube array sheet and the fixture sheet, and
calcining the carbon nanotube array sheet and the fixture sheet between which the metal thin film is disposed under vacuum or inert atmosphere.

6. A method for producing a carbon nanotube bonded sheet, the method comprising the steps of:
preparing a resin sheet containing inorganic particles,
allowing vertically-aligned carbon nanotube to grow on a growth substrate,
removing the vertically-aligned carbon nanotube from the growth substrate to form a carbon nanotube array sheet,
disposing the carbon nanotube array sheet on the resin sheet, and
calcining the resin sheet on which the carbon nanotube array sheet is disposed under vacuum or inert atmosphere.

7. A method for producing a carbon nanotube bonded sheet, the method comprising the steps of:
allowing vertically-aligned carbon nanotube to grow on a growth substrate,
removing the vertically-aligned carbon nanotube from the growth substrate to form a carbon nanotube array sheet,
applying a paste containing inorganic particles to the carbon nanotube array sheet, and
calcining the carbon nanotube array sheet to which the paste is applied under vacuum or inert atmosphere.
